# EUROPEAN PATENT APPLICATION

(11) **EP 2 594 842 A1**
(43) Date of publication of application: **22.05.2013**
(21) Application number: 11806467.4
(22) Date of filing: 08.07.2011
(51) Int. Cl.: F21S 2/00, F21V 3/04, F21V 29/00, H01S 5/022, F21Y 101/02

(54) **LIGHT SOURCE DEVICE**

(30) Priority: 12.07.2010 JP 2010157834
(71) Applicant: Toshiba Lighting & Technology Corporation, Yokosuka-shi Kanagawa 237-8510 (JP)
(72) Inventor: TAKEDA, Yuji, Kanagawa 2378510 (JP)
(74) Representative: Kramer - Barske - Schmidtchen
(86) International application number: PCT/JP2011/003941
(87) International publication number: WO 2012/008132

(57) **Abstract**

Disclosed is a light source device that is a globe-type light source that uses a laser diode (LD) and that obtains white light emission with a high light flux and is almost uniform in all directions. The light source device has a dual-tube structure comprising a transparent light-emitting tube (11) and a transparent outer tube (15). The light-emitting tube (11) is sealed (112) and the tip of the straight tube (111) is rounded. A fluorescent material layer (12) is formed on an inner surface of a light-emitting region (11a) in the light-emitting tube (11) in the vicinity of the seal (112) and a reflective film (13) is formed on an inner surface of a straight tube region (11b) which is a non-light-emitting section of the light-emitting tube (11). The outer tube (15) is frosted (151). The LD (16) with suppressed temperature increase and attached to a heat radiator (17) is disposed on the release end section of the light-emitting tube (11) and the fluorescent material emits light by the LD (16) radiating laser light on the fluorescent material layer (12). This enables white light emission that has high light flux and is almost uniform in all direction to be obtained while using an LD.

## Description

### TECHNICAL FIELD

Embodiments according to the present invention relate to a globe-type light source device that emits a light generated from a laser diode (LD) as an excitation light of a fluorescent material on the fluorescent material, thereby to obtain a white light.

### BACKGROUND ART

Conventionally, a light source device using ultraviolet light emitting diode (UV-LED) and blue light emitting diode radiates a ultraviolet light and a blue light on a fluorescent material, thereby to emit a white light.

### CITATION LIST

### PATENT LITERATURE

PLT 1: Japanese Patent Application Laid-Open No. 2001-156338

### SUMMARY OF THE INVENTION

### TECHNICAL PROBLEM

The technique in Patent Literature 1 has an advantage that since a ultraviolet light is radiated toward a fluorescent material layer on the inner surface of the tip of a glass tube from a UV-LED and a visible light is radiated from a fluorescent material, any emitting color can be obtained by adjusting a blend rate of the fluorescent material at lower consumed power than a filament lamp and mercury is not used thereby to be more environmentally friendly than a mercury fluorescent lamp.

However, a ultraviolet light radiated from the UV-LED is applied only on the top of the glass tube, and thus only the top of the glass tube emits a light and is poor-looking, and a LED chip is floating inside the glass tube so that a temperature of the LED chip easily increases, and there is therefore a problem that a large amount of power is difficult to power into the UV-LED and a light with a high light flux cannot be obtained.

The embodiments are directed for providing a light source device capable of obtaining white light emission which is with a high light flux and is almost uniform in all directions.

### SOLUTION TO PROBLEM

According to the embodiments, there are provided a light emitting tube which is formed by sealing one end as the tip of a translucent straight tube, a fluorescent material layer formed on the tip of the light emitting tube, a laser diode which is arranged inside an open end at the other end of the straight tube and radiates a laser light on the fluorescent material layer, and a heat radiator which supports the laser diode and restricts heat generation of the diode.

### BRIEF DESCRIPTION OF THE DRAWINGS

FIG. 1 is an outer profile view for explaining a light source device according to a first embodiment.
FIG. 2 is a cross-section view for explaining a structure of FIG. 1.
FIG. 3 is a cross-section view illustrating enlarged essential parts of FIG. 2.
FIG. 4 is a cross-section view for explaining a light source device according to a second embodiment.
FIG. 5 is a cross-section view for explaining a light source device according to a third embodiment.
FIG. 6 is an outer profile view for explaining a light source device according to a fourth embodiment.
FIG. 7 is a top view of FIG. 6.
FIG. 8 is a cross-section view taken along the line Ia-Ib of FIG. 7.
FIG. 9 is a top view with a light emitting tube and a protective cover removed.

### DESCRIPTION OF EMBODIMENTS

Embodiments will be described below in detail with reference to the drawings.

### (First Embodiment)

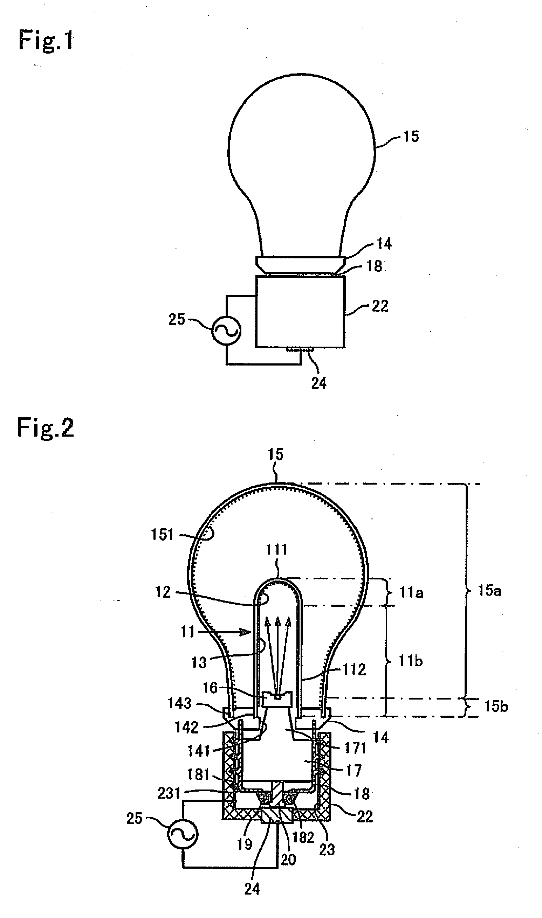

FIG. 1 and FIG. 2 explain a light source device according to a first embodiment, where FIG. 1 is an outer profile view and FIG. 2 is a cross-section view for explaining an inner surface structure of FIG. 1.

In FIG. 1 and FIG. 2, 11 denotes a light emitting tube one end of a straight tube 111 of which is sealed 112 to be rounded and which is made of quartz glass, borosilicate glass or transparent resin, for example. A fluorescent material layer 12 applied with a fluorescent material is formed on the inner surface of a light emitting region 11a at the tip of the light emitting tube 11. A reflective film 13 such as barium sulfate layer is formed between the light emitting region 11a of the light emitting tube 11 and the inner surface of a straight tube region 11b at the other end side.

14 denotes a support member made of, for example, synthetic resin which is heat resistant and on which an opening 141 is formed at the center. An open end of the light emitting tube 11 in the straight tube region 11b is attached to a stepped support portion 142 formed on the opening 141 by use of a fixing means such as adhesive. The stepped support portion 142 is formed on the opening 141, but may have a groove shape according to the shape of an open portion of the light emitting tube 11.

15 denotes a filament lamp-shaped outer tube made of glass or translucent resin having a translucency, for example, in which the light emitting tube 11 is housed. The outer tube 15 is formed of a dome-shaped light emitting region 15a as a light emitting portion and a base region 15b as an attachment portion, and an open end of the outer tube 15 in the base region 15b is attached to a support portion 143 formed on the support member 14 by use of a fixing means such as adhesive. The support portion 143 is formed in a groove shape according to the open portion of the outer tube 15, but may be formed with a step outside the support member 14 like the support portion 142 supporting the light emitting tube 11. The inner surface of the outer tube 15 is frosted 151 for diffusing an incident light.

The outer tube 15 is designed to be similar to a current filament lamp in its outer profile, and is not necessarily needed. The outer surface of the outer tube 15 is frosted 151 to have a similar diffusion effect.

16 denotes a LD arranged inside the open end of the light emitting tube 11 in a state in which a radiation portion for emitting a laser light is opposed to the fluorescent material layer 12. The LD 16 is attached on an attachment portion 171 formed on part of a heat radiator 17 which partially passes inside the opening 141 of the support member 14 and which incorporates a power supply circuit (not illustrated) for acquiring a DC voltage necessary for driving the LD 16.

The LD 16 has a fan-shaped light distribution of about 10°, for example. The light distribution angles of the LD are different between about 10° in the horizontal direction and about 40° in the vertical direction and a radiation area is rectangular, but an explanation will be made assuming an angle of 10°.

18 denotes a bottomed conductive nozzle through which the heat radiator 17 is housed. A male screw 181 is formed on the outer periphery of the nozzle 18 and a throughhole 182 is formed on the bottom thereof. The nozzle 18 is electrically connected to one input end of the power supply circuit. An open end of the nozzle 18 is attached to the groove formed on the support member 14 by use of a fixing means such as adhesive.

The throughhole 182 is fixed with an electrode 20 which is electrically connected to the other input end of the power supply circuit via an insulative material 19 for insulation from the nozzle 18. Thereby, the nozzle 18 and the electrode 20 are electrically connected to the power supply circuit so that the support member 14, the light emitting tube 11 and the outer tube 15 are integrally configured.

22 denotes an insulative socket which is bottomed and cylindrical. A conductive receiving port 23 formed with a female screw 231 into which the male screw 181 of the nozzle 18 is screwed is attached on the inner surface of the socket 22. The socket 22 is arranged at the bottom with a connection terminal 24 electrically connected to an electrode 19 with the nozzle 18 screwed. Typically, the socket 22 is attached on the lamp fitting side and the nozzle 18 is detachably attached to the fitting.

The nozzle 18 is connected to one electrode of an AC power supply 25 and the connection terminal 24 is connected to the other electrode of the AC power supply 25. The AC power supply 25 is supplied to the power supply circuit to be converted from AC to DC, and can supply drive power to the LD 16.

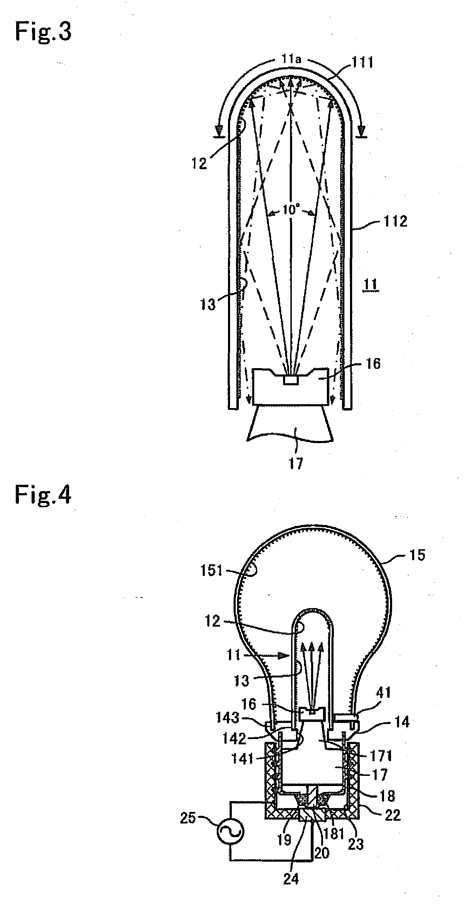

Light emission of the light source device of FIG. 2 will be described with reference to FIG. 3 illustrating the enlarged light emitting tube 11 of FIG. 2.

At first, when an AC voltage of the AC power supply 25 is supplied to the power supply circuit housed in the heat radiator 17, it is converted into a DC voltage in the power supply circuit. The DC voltage is supplied to the LD 16 so that the LD 16 radiates a VU laser light. The laser light travels inside the light emitting tube 11 with a directivity of about 10°, and finally reaches the fluorescent material layer 12 at the tip to be absorbed in the fluorescent material layer 12, thereby emitting a white light. The white light is radiated on the outer tube 15 side based on the light emission of the fluorescent material layer 12.

A laser light which is reflected instead of being absorbed in the fluorescent material layer 12 indicated with broken arrows in FIG. 3 and a laser light spreading at more than 10° from the LD 16 indicated in chained lines are reflected on the reflective film 13 to be radiated on the fluorescent material layer 12 again, thereby being converted into a white light.

In this way, the laser light radiated from the LD 16 is radiated at a fan-shaped light distribution of about 10°, and the reflective film 13 is formed on the inner surface of the straight tube region 11b of the light emitting tube 11 so that a band-like strong light is emitted only in the light emitting region 11a at the tip of the light emitting tube 11. When this is viewed over the outer tube 15, it seems as if a filament was lighting in a filament lamp.

The white light radiated on the outer tube 15 side is diffused by the frosting 151 formed on the inner surface of the outer tube 15 thereby to obtain a similar illuminance from the outside of the outer tube 15.

According to the embodiment, a LD having a stronger directivity than a LED is used as a fluorescent material excitation light source, thereby efficiently guiding a laser light up to a fluorescent material applied portion at the tip of the light emitting tube. Since the LD can be arranged at the end of the light source, heat radiation from the LD can be easily performed by a heat radiating means such as heat radiator, thereby applying more power and obtaining a light with a higher light flux.

A conceptual example of a method for forming the light emitting tube 11 according to the embodiment illustrated in FIG. 2 will be described with reference to the following respective steps (1) to (5).
(1) Heat one end of the glass tube of the straight tube with a burner.
(2) Put the other end of the glass tube in a preheated metal mold, put high-pressure air into the glass tube, and round the light emitting region 11a.
(3) Slowly cool the tip of the glass tube such that no distortion remains.
(4) Form the fluorescent material layer 12 on the inner surface as the light emitting region 11a.
(5) Form a barium sulfate layer as the reflective film 13 on the inner surface of the straight tube region 11b as the straight tube inside the glass tube.
In this way, the fluorescent material layer 12 and the reflective film 13 can be formed inside the light emitting tube 11 through the respective steps (1) to (5).

A two-layer structure including the fluorescent material layer 12 may be employed in the step (5) of forming the reflective film 13 as the barium sulfate layer. In this case, the fluorescent material layer 12 is formed to be positioned on the glass tube side.

A conceptual example of a method for forming the fluorescent material layer 12 and the reflective film 13 in the light emitting tube 11 in the straight tube region 11b will be described below with reference to the following respective steps (a) to (f).
(a) Flow, into the glass tube, fluorescent slurry made of fluorescent powder having, for example, a mix ratio (I:II) at which an apatite-based blue fluorescent material (I) and a silicate-based yellow fluorescent material (II) have optimum color temperatures such as (90 wt/%:10 wt/%) to (95 wt/%:5 wt/%), and a solvent of, for example, butyl acetate, soluble nitrocellulose and calcium pyrophosphate.
(b) Face the tip of the light emitting tube 11 upward, feed drying air into the light emitting tube 11 by use of a thin metal pipe, and dry the fluorescent material.
(c) Scrape the fluorescent material positioned in the straight tube region 11b by use of a thin comb-shaped jig.
(d) Face the tip of the light emitting tube 11 upward, immerse the straight tube region 11b into barium sulfate slurry made of barium sulfate powder and solvent (butyl acetate, soluble nitrocellulose and calcium pyrophosphate). When immersed, if a pressure inside the light emitting tube 11 is the same as an atmosphere pressure, the barium sulfate slurry cannot enter the light emitting tube 11. The light emitting tube 11 is immersed into the barium sulfate slurry with a metal rod put inside the light emitting tube 11, the metal rod is picked out with the light emitting tube 11 immersed and the pressure inside the light emitting tube 11 is lowered, thereby flowing the barium sulfate slurry into the light emitting tube 11.
(e) Face the tip of the light emitting tube 11 upward, feed drying air into the light emitting tube by use of a thin metal pipe, and dry the barium sulfate layer.
(f) Heat the light emitting tube 11 at about 500 °C for 10 minutes, remove the solvent inside the fluorescent material layer 12 and the barium sulfate layer, and dissolve a binder to fix a fluorescent material and barium sulfate onto the inner surface of the light emitting tube.
There is an advantage that when the barium sulfate layer formed in the straight tube region 11b is formed on the fluorescent material layer 12, the step (c) can be omitted.

The fluorescent material layer and the reflective film layer are provided inside the straight tube in the above description, but may be provided outside the straight tube. Also in this case, a similar effect can be obtained as when they are provided inside the straight tube.

A combination of a laser light wavelength and a fluorescent material may be a combination of a laser light with a wavelength of 405 nm, an apatite-based blue fluorescent material and a silicate-based yellow fluorescent material, a combination of a laser light with a wavelength of 455 nm and a silicate-based yellow fluorescent material, a combination of a laser light with a wavelength of 455 nm and a YGA-based yellow fluorescent material, and the like.

### (Second Embodiment)

FIG. 4 explains a light source device according to a second embodiment. The embodiment obtains safety when a light source using LD is configured. Like reference numerals are denoted to like reference parts identical to those in the above embodiment, and an explanation thereof will be omitted. This is also applicable to the following embodiments.

The light source device is provided with a sensor 41 for detecting an abnormality mode when the light emitting tube 11 or the outer tube 15 comes off the support member 14 during drive or when an unusual impact or outer pressure, which can cause either the light emitting tube 11 or the outer tube 15 to break, is applied or either one breaks. The sensor 41 may be a sound sensor for detecting a glass breaking sound and outputting a detection signal, or a vibration impact sensor for detecting a vibration occurring due to application of an impact or outer pressure and outputting a detection signal.

When the sensor 41 detects the abnormality mode, a detection signal is output from the sensor 41. The power supply circuit is stopped based on the detected signal thereby to stop the LD 16. The radiation of a laser light from the LD 16 is stopped thereby to eliminate safety problems when the light emitting tube 11 or the outer tube 15 breaks.

### (Third Embodiment)

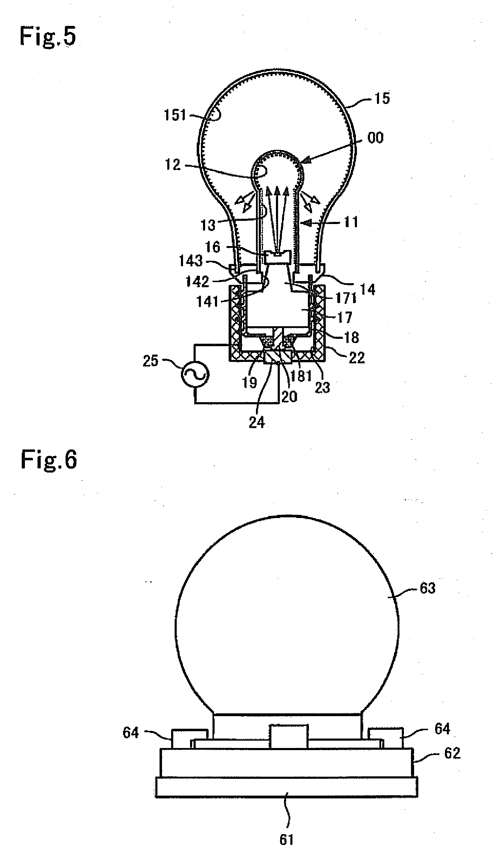

FIG. 5 explains a light source device according to the third embodiment. The embodiment is such that the light emitting region 11a of the light emitting tube 11 is formed in a dome shape so that its outer side is larger than the outer shape of the straight tube region 11b. In this case, the light emitting region 11a is larger than the outer shape of the straight tube region 11b and correspondingly the fluorescent material layer 12 also spreads outside.

In the embodiment, a white light can be emitted also toward the nozzle 18 as indicated in white arrows in the figure, thereby realizing a lamp closer to a filament lamp. Thus, a reflector can be efficiently used in a downlight with the reflector.

### (Fourth Embodiment)

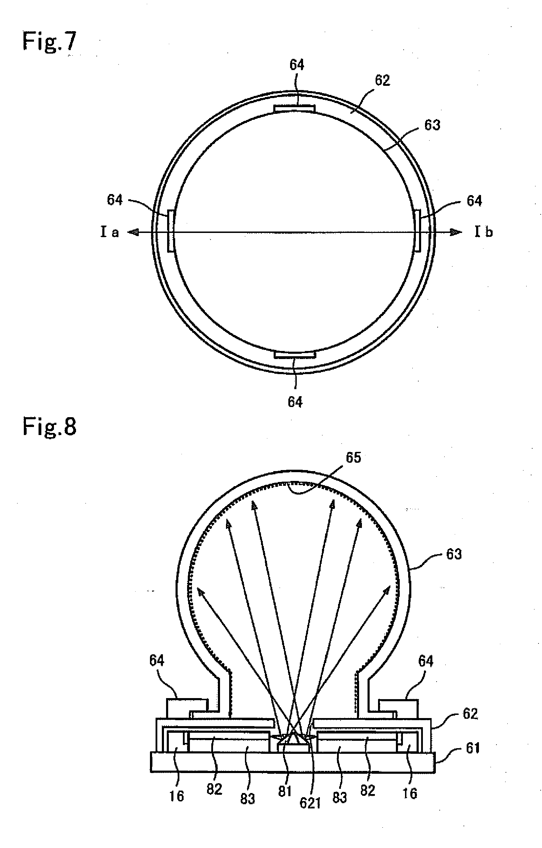

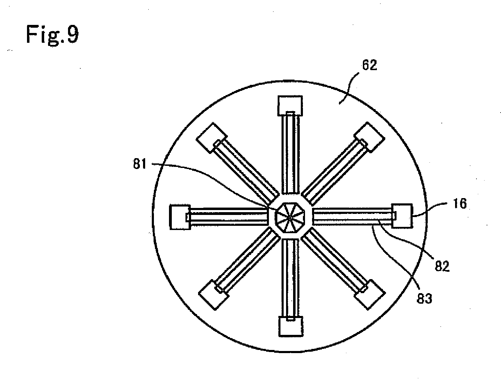

FIGS. 6 to 9 explain a light source device according to a fourth embodiment, where FIG. 6 is an outer profile view, FIG. 7 is a top view of FIG. 6, FIG. 8 is a cross-section view taken along the line Ia-Ib of FIG. 7, and FIG. 9 is a top view with the light emitting tube and the protective cover of FIG. 7 removed. The embodiment employs a plurality of LDs.

An outer profile of the embodiment will be described first with reference to FIG. 6 and FIG. 7. 61 denotes a heat radiating plate also as a pedestal. A protective cover 62 is attached on the heat radiating plate 61. For example, a quartz glass light emitting tube 63 in a dome shape is further held by four holding members 64 arranged at substantially uniform intervals on the protective cover 62. At least two of the four holding members are removable or movable in their hook portions, and thus the light emitting tube 63 can be attached and detached. A fluorescent material layer 65 is applied on the inner surface of the light emitting tube 63.

The four holding members are employed, but more or less holding members may be employed, or the number is not limited and any number of holding members capable of holding the light emitting tube 63 is possible.

As illustrated in FIG. 8 and FIG. 9, a reflector 81 in an eight-sided pyramid shape is arranged at the center on the heat radiating plate 61 in the protective cover 62. The surface of the reflector 81 is subjected to silver deposition known as a material capable of efficiently reflecting a laser light. The protective cover 62 opposite to the reflector 81 is formed with an illumination hole 621 for passing a laser light.

The corresponding LDs 16 are attached onto the heat radiating plate 61 radially arranged at predetermined intervals from the reflective surface of the reflector 81. Light guide members 82 which have a rod shape and are made of quartz glass, for example, are arranged between the laser light output units of the LDs 16 and the reflector 81. The light guide member 82 is attached to a support portion 83 attached on the heat radiating plate 61.

In the thus-configured light source device, laser lights are radiated all together from the LDs 16 supplied with a DC voltage from the power supply circuit. The laser light is reflected on the corresponding reflector 81 via the light guide member 82, and emits on a fluorescent material 65 on the inner surface of the light emitting tube 63 via the illumination hole 621 to be radiated to the outside from the light emitting tube 63.

According to the embodiment, laser rights are radiated from eight LDs via the light guide members so that the respective LDs can be arranged away from each other, thereby restricting a temperature of the LDs to be low. Consequently, an efficient light source with a high light flux and a large amount of light can be realized. Thereby, a mercury-free light source with low power consumption can be obtained.

When the angles of the eight reflective surfaces of the reflector 81 are changed, the effect of the frosting 151 applied on the inner surface of the outer tube 15 in FIG. 2 can be maintained. Fins or the like are formed on the heat radiating plate 61 to increase the surface area, thereby enhancing a heat radiating effect so that power capable of being applied to the LDs 16 can be increased, thereby enhancing an illuminance.

A plurality of LDs, not limited to eight, may be arranged at different positions in the embodiment. The LDs are arranged in a balanced manner so that an influence of heat generation between the LDs can be restricted, thereby contributing to an increase in light emission efficiency. Since the laser light emitted from the LD is excellent in linearity, the light guide member 82 is not necessarily needed, and may be omitted and the laser lights may be directly reflected on the reflector.

Some embodiments have been described above, but the embodiments are exemplary and do not intend to limit the scope of the invention. The novel embodiments may be performed in other various forms, and can be variously omitted, replaced or changed without departing from the spirit of the invention. The embodiments or their variants are encompassed in the scope or spirit of the invention, and are encompassed in the invention described in Claims and their equivalents.

### REFERRENCE SIGN LIST

| | |
|---|---|
| 11, 63: | Light emitting tube |
| 111: | Straight tube |
| 112: | Seal |
| 11a: | Light emitting region |
| 11b: | Straight tube region |
| 12: | Fluorescent material layer |
| 13: | Reflective film |
| 14: | Support member |
| 15: | Outer tube |
| 151: | Frost |
| 15a: | Light emitting region |
| 16: | LD |
| 17: | Heat radiator |
| 171: | Attachment portion |
| 18: | Nozzle |
| 181: | Male screw |
| 20: | Electrode |
| 22: | Socket |
| 23: | Receiving port |
| 231: | Female screw |
| 61: | Heat radiating plate |
| 65: | Fluorescent material layer |
| 81: | Reflector |
| 82: | Optical light guide member |

## Claims

1. A light source device comprising:
a light emitting tube formed by sealing one end as the tip of a translucent straight tube;
a fluorescent material layer formed at the tip of the light emitting tube;
a laser diode which is arranged inside an open end of the other end of the straight tube and radiates a laser light on the fluorescent material layer; and
a heat radiator which supports the laser diode and restricts heat generation of the diode.

2. The light source device according to claim 1, wherein a reflective film is formed on a straight tube portion of the light emitting tube.

3. The light source device according to claim 1, wherein the light emitting tube is housed in a translucent outer tube having a function of diffusing a visible light emitted from the light emitting tube.

4. The light source device according to claim 2, wherein the light emitting tube is housed in a translucent outer tube having a function of diffusing a visible light emitted from the light emitting tube.

5. The light source device according to claim 1, wherein a nozzle which is attached on a support member for supporting open ends of the light emitting tube and the outer tube and is supplied with power from the outside is attached.

6. The light source device according to claim 2, wherein a nozzle which is attached on a support member for supporting open ends of the light emitting tube and the outer tube and is supplied with power from the outside is attached.

7. The light source device according to claim 3, wherein a nozzle which is attached on a support member for supporting open ends of the light emitting tube and the outer tube and is supplied with power from the outside is attached.

8. The light source device according to claim 4, wherein a nozzle which is attached on a support member for supporting open ends of the light emitting tube and the outer tube and is supplied with power from the outside is attached.

9. The light source device according to claim 1, wherein a plurality of laser diodes are arranged at different positions, and laser lights radiated from the diodes are radiated on the fluorescent material layer via a reflector.
